Europäisches Patentamt

European Patent Office

Office européen des brevets

(19)

(11) Numéro de publication : **0 424 255 B1**

(12) **FASCICULE DE BREVET EUROPEEN**

(45) Date de publication du fascicule du brevet :
**14.06.95 Bulletin 95/24**

(51) Int. Cl.⁶ : **H03H 7/07**

(21) Numéro de dépôt : **90402916.2**

(22) Date de dépôt : **17.10.90**

(54) **Cellule de filtrage et filtre correspondant.**

(30) Priorité : **19.10.89 FR 8913687**

(43) Date de publication de la demande :
**24.04.91 Bulletin 91/17**

(45) Mention de la délivrance du brevet :
**14.06.95 Bulletin 95/24**

(84) Etats contractants désignés :
**BE DE FR GB IT**

(56) Documents cités :
**FR-A- 1 159 815**
**US-A- 1 611 932**
**TOUTE L'ELECTRONIQUE, no. 413, août-septembre 1976, pages 59-63, Paris, FR; J. GOUREVITCH: "Les filtres elliptiques plats"**
**PATENT ABSTRACTS OF JAPAN, vol. 10, no. 170 (E-412)[2226], 17 juin 1986;**

(73) Titulaire : **FRANCE TELECOM exploitant public**
**6, place d'Alleray**
**F-75015 Paris (FR)**
Titulaire : **TELEDIFFUSION DE FRANCE**
**10, rue d'Oradour sur Glane**
**F-75932 Paris Cédex 15 (FR)**

(72) Inventeur : **Havot, Henri**
**13 rue de la Prée**
**F-35510 Cesson Sevigne (FR)**
Inventeur : **Dutertre, Yvon**
**Le Patis**
**F-35690 Acigne (FR)**

(74) Mandataire : **Signore, Robert et al**
**c/o BREVATOME**
**25, rue de Ponthieu**
**F-75008 Paris (FR)**

## Description

La présente invention a pour objet une cellule de filtrage et un filtre correspondant. Elle trouve de multiples applications en électronique et notamment dans la réalisation de filtres réjecteurs, de filtres passe-bas ou de filtres passe-haut. Cette technique de filtrage peut s'appliquer en particulier dans les réseaux câblés de vidéocommunications lorsqu'il s'agit de filtrer certains canaux de télévision.

L'invention s'applique à tous les filtres comprenant une ou des cellules comprenant un circuit résonnant composé d'au moins une réactance d'un premier type inductif ou capacitif (cette réactance étant donc soit une inductance soit un condensateur) et d'au moins une réactance d'un second type opposé au premier, capacitif ou inductif (et consistant donc en un condensateur ou une inductance). De telles cellules peuvent être disposées en série, ou en parallèle, avec des structures en $\pi$, en T, en treillis, etc... Cependant, pour simplifier la description qui va suivre, on s'en tiendra aux cellules de type résonnant-parallèle, montées en série sans qu'il s'agisse d'une limitation de la portée de l'invention.

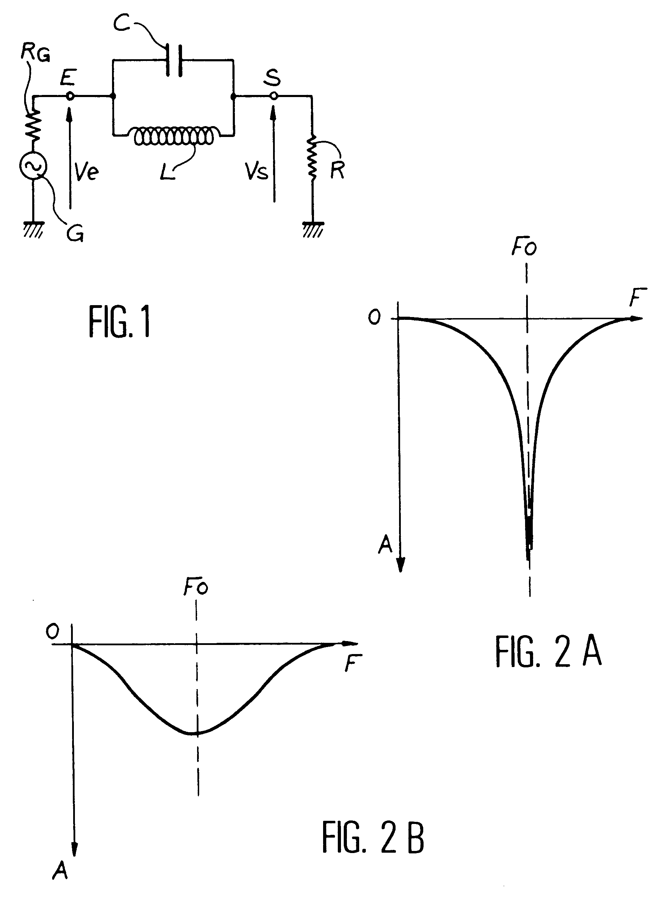

Une cellule de filtrage de type résonnant-parallèle selon l'art antérieur est représentée sur la figure 1 annexée. Cette cellule comprend un condensateur C et une inductance L formant un circuit résonnant à la fréquence $Fo = 1/2\pi\sqrt{LC}$. Une entrée E est reliée à un générateur G d'impédance de sortie $R_G$ et une sortie S à une charge R. Les tensions à l'entrée E et à la sortie S sont notées respectivement Ve et Vs.

La réponse théorique d'un tel filtre est représentée sur la figure 2A. Sur l'axe des ordonnées est portée l'atténuation A, c'est-à-dire le rapport Vs/Ve, compté en décibels (ce rapport est négatif). L'axe des abscisses correspond à la fréquence F. A la fréquence Fo, l'atténuation est en principe infiniment grande.

En réalité, les composants utilisés pour constituer une telle cellule ne sont pas parfaits et l'inductance, en particulier, possède une résistance qui est loin d'être négligeable. L'amortissement qui en résulte a pour effet de modifier sensiblement la courbe d'atténuation, qui prend alors l'allure représentée sur la figure 2B. Il existe toujours une fréquence où l'atténuation est maximale (en valeur absolue), mais cette atténuation a une valeur finie (par exemple 20 ou 30 dB). Elle peut se révéler insuffisante dans la pratique lorsqu'il s'agit d'obtenir une réjection efficace ou d'obtenir une coupure nette.

On sait corriger une cellule LC parallèle montée en série en scindant le condensateur en deux et en connectant au point milieu ainsi obtenu une résistance reliée à la masse. C'est ce qui est décrit par exemple dans le document FR-A-1 159 815. La réjection obtenue est importante mais les pertes en deçà et au-delà de la fréquence réjectée sont importantes. De plus, l'adaptation n'est pas satisfaisante.

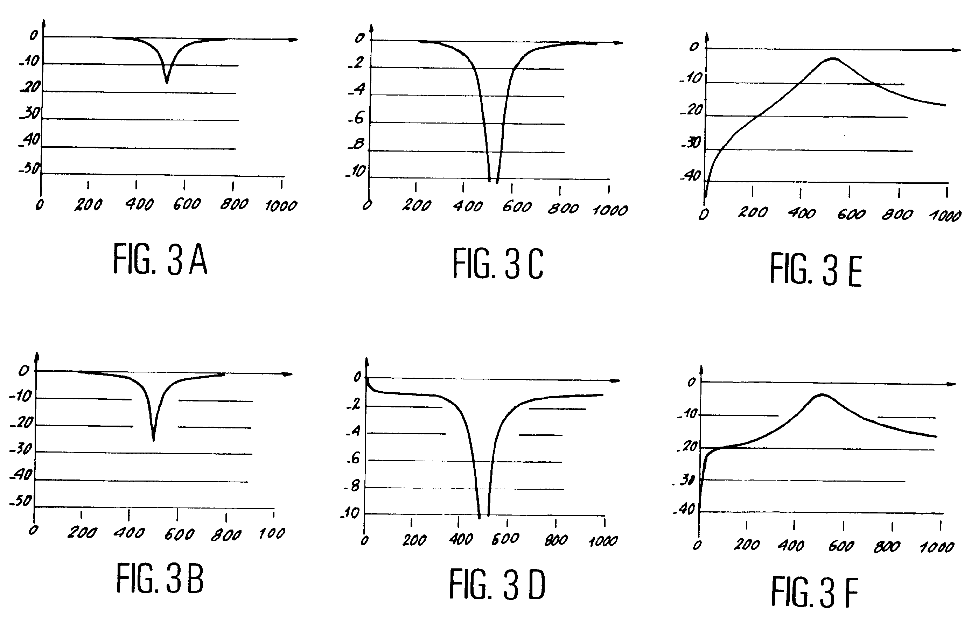

Les figures 3A à 3F précisent ces questions. La figure 3A d'abord montre l'atténuation d'une cellule particulière LC non corrigée où l'atténuation est portée en ordonnées et la fréquence en abscisses. A la fréquence de réjection, l'atténuation est de - 18 dB. En corrigeant la cellule par une simple résistance on obtient les valeurs de la figure 3B. L'atténuation à la réjection est de - 28 dB. La figure 3C montre de façon plus précise l'atténuation de part et d'autre de la fréquence de réjection pour la cellule LC non corrigée. On obtient par exemple 0,2 dB à 800 MHz et 2 dB à 600 MHz. La figure 3D montre de la même manière cette atténuation pour la même cellule corrigée par une résistance. On obtient une atténuation de 1,2 dB à 800 MHz et 2,5 dB à 600 MHz.

Les figures 3E et 3F montrent la désadaptation de la cellule respectivement non corrigée (-13 dB à 800 MHz) et corrigée par une résistance (-13 dB à 800 MHz).

Le document cité FR-A-1 159 815 décrit aussi un filtre où l'on associe à la résistance une inductance variable pour compenser la valeur de la résistance lorsque celle-ci n'a pas la valeur idéale.

Dans le document PATENT ABSTRACTS OF JAPAN, vol. 10, n°170 (E-412)(2226), 17 juin 1986, il est décrit un filtre passe-bande avec deux inductances en parallèle sur un condensateur, et avec un condensateur supplémentaire connecté au milieu des deux inductances pour produire deux pôles d'atténuation et obtenir, entre ces deux pôles, une bande de blocage.

La présente invention a pour but de remédier aux inconvénients de l'art antérieur et vise à corriger de manière simple les filtres existants afin d'obtenir à la fois une atténuation plus grande à la fréquence de résonance Fo et une meilleure adaptation vers les basses fréquences. En d'autres termes, la pente de la droite joignant le point de la courbe d'affaiblissement à la fréquence Fo et le point de cette même courbe à une fréquence plus basse déterminée, est considérablement augmentée par rapport à l'art antérieur.

Après des travaux théoriques et expérimentaux sur les filtres, les inventeurs ont trouvé que le défaut de qualité de l'inductance ou du condensateur n'était pas un handicap insurmontable mais pouvait être corrigé si l'on associait à l'inductance un condensateur de valeur appropriée ou au condensateur une inductance de valeur appropriée. En d'autres termes, l'invention propose de corriger le coefficient de qualité du circuit résonnant et cela soit en agissant sur l'inductance soit en agissant sur le condensateur, soit en agissant sur les deux.

La cellule ayant été ainsi corrigée, les inventeurs ont montré que l'atténuation à la fréquence de résonance était considérablement augmentée.

Il faut observer que la fréquence correspondant au maximum d'atténuation se trouve légèrement déplacée par l'ajout de la réactance de correction. Si besoin est, on peut toujours corriger cet effet en modifiant la valeur des réactances de la cellule pour ramener la fréquence à la valeur avant correction. Par exemple, dans le cas de la correction de l'inductance, il suffira d'augmenter la valeur du condensateur principal d'une fraction de la capacité du condensateur de correction.

Le perfectionnement apporté par l'invention s'accompagne d'un autre avantage, qui est de parfaire l'adaptation d'impédance de la cellule de filtrage. La partie de l'énergie réfléchie par la cellule tombe en effet, après correction, à une valeur très faible (-20 dB par exemple) pour les fréquences inférieures à la fréquence de résonance. En d'autres termes, le coefficient de réflexion est quasiment nul et le taux d'onde stationnaire proche de l'unité.

On observera que ces hautes performances sont obtenues en dépit de la qualité médiocre de l'inductance ou du condensateur. La cellule de filtrage de l'invention s'accommode donc de composants peu chers.

Par ailleurs, et comme on le comprendra mieux par la suite, l'invention se prête particulièrement bien à la technologie à micro-ruban où les inductances peuvent présenter un coefficient de qualité médiocre sur certains substrats ce qui à tendance à dégrader les performances des filtres.

De façon précise, la présente invention a pour objet une cellule de filtrage comprenant un circuit résonnant parallèle composé d'au moins une inductance et d'au moins un condensateur, caractérisée par le fait que l'inductance est séparée en deux inductances connectées en série avec un point milieu, et par le fait qu'elle comprend un condensateur de correction connecté audit point milieu, ce condensateur de correction ayant une capacité de valeur sensiblement égale à $L/R^2$, où L est la valeur de l'inductance et R la valeur de l'impédance de charge de la cellule, le condensateur de correction ayant un coefficient de qualité sensiblement égal au coefficient de qualité de l'inductance.

La présente invention a également pour objet une cellule de filtrage comprenant un circuit résonnant parallèle composé d'au moins une inductance et d'au moins un condensateur, caractérisée par le fait que le condensateur est séparé en deux condensateurs connectés en série avec un point milieu et par le fait qu'elle comprend une inductance de correction de valeur Lc associée à une résistance de valeur Rc et connectée audit point milieu, cette inductance de correction étant inférieure ou égale sensiblement à $1/2R_1C^2w_o^3$ où C est la valeur du condensateur, $R_1$ la résistance de l'inductance et $w_o$ la pulsation de résonance.

Bien que le type de cellule employé puisse être quelconque, le type résonnant-parallèle, monté en série semble se prêter particulièrement bien à la mise en oeuvre de l'invention.

Selon l'invention, le condensateur de correction peut être non plus localisé mais réparti.

La présente invention a également pour objet un filtre comprenant une pluralité de cellules de filtrage, ce filtre étant caractérisé par le fait qu'au moins l'une de ces cellules est conforme à l'une quelconque des cellules qui viennent d'être définies.

De toute façon, les caractéristiques et avantages de l'invention apparaîtront mieux à la lumière de la description qui va suivre. Cette description porte sur des exemples de réalisation donnés à titre explicatif et nullement limitatif et elle se réfère à des dessins annexés sur lesquels :

- la figure 1, déjà décrite, montre une cellule de filtre réjecteur selon l'art antérieur,
- les figures 2A et 2B, déjà décrites, montrent l'atténuation théorique et l'atténuation réellement obtenue avec un filtre de l'art antérieur de la figure 1,
- les figures 3A à 3F, déjà décrites, montrent des courbes de performances de cellules de l'art antérieur avec une résistance de correction,
- la figure 4 montre un filtre selon l'invention dans une variante à cellule de type résonnant-parallèle, montée en série, avec correction sur l'inductance,
- la figure 5 montre l'atténuation obtenue avec un filtre de la figure 4,
- la figure 6 montre un cas pratique de réalisation d'un filtre réjecteur selon l'art antérieur,
- la figure 7 montre un cas pratique de réalisation d'un filtre réjecteur selon l'invention, avec correction sur l'inductance,
- les figures 8 et 9 montrent la réjection du filtre de la figure 6,
- les figures 10 et 11 montrent la réjection du filtre de la figure 7,
- la figure 12 illustre une cellule en $\pi$, corrigée selon l'invention,
- la figure 13 montre l'atténuation obtenue avec le filtre précédent,
- la figure 14 montre un filtre réjecteur comprenant trois cellules selon l'invention,
- la figure 15 illustre un mode de réalisation d'une cellule à micro-ruban,
- la figure 16 montre un filtre replié à quatre cellules à micro-ruban.
- la figure 17 montre un filtre selon l'invention dans un mode de réalisation où la correction s'effectue par une inductance connectée entre deux condensateurs,
- les figures 18A, 18B, 18C illustrent les performances obtenues dans le cas du filtre de la figure précédente.

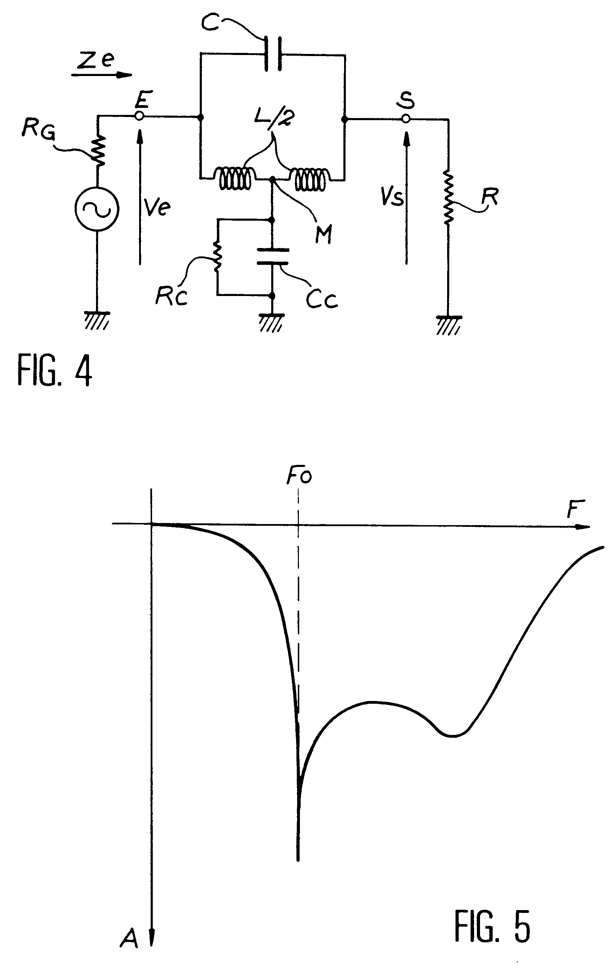

On voit sur la figure 4 une cellule de filtrage selon l'invention, dans le cas particulier d'un circuit résonnant-parallèle monté en série et dans un mode de réalisation correspondant à la correction sur l'inductance. Cette cellule comprend, comme pour la figure 1 déjà décrite, un condensateur C et une inductance de valeur L, cette dernière étant toutefois partagée en deux inductances de valeur L/2 avec un point milieu M. Un condensateur de correction Cc est connecté entre le point milieu M de l'inductance et la terre. Ce condensateur possède, soit intrinsèquement soit par le jeu d'une résistance volontairement connectée en parallèle, une résistance Rc. La valeur de la capacité Cc est prise égale à $L/R^2$ où L est la somme des deux moitiés de l'inductance (L/2+L/2) et R la valeur de la charge. Quant au coefficient de qualité RcCcw, il est égal à celui de l'inductance soit Lw/r où r est la résistance de l'inductance. La résistance Rc est donc prise égale à L/rCc.

L'atténuation obtenue dans ces conditions est représentée sur la figure 5. A la fréquence Fo, l'atténuation est sensiblement plus grande que dans l'art antérieur (cf Figure 3). Il apparaît en outre après la fréquence Fo un second pôle ou point de réjection. En général, ces modifications n'ont aucune importance s'il s'agit de couper la fréquence Fo ou d'obtenir un filtre passe-bas.

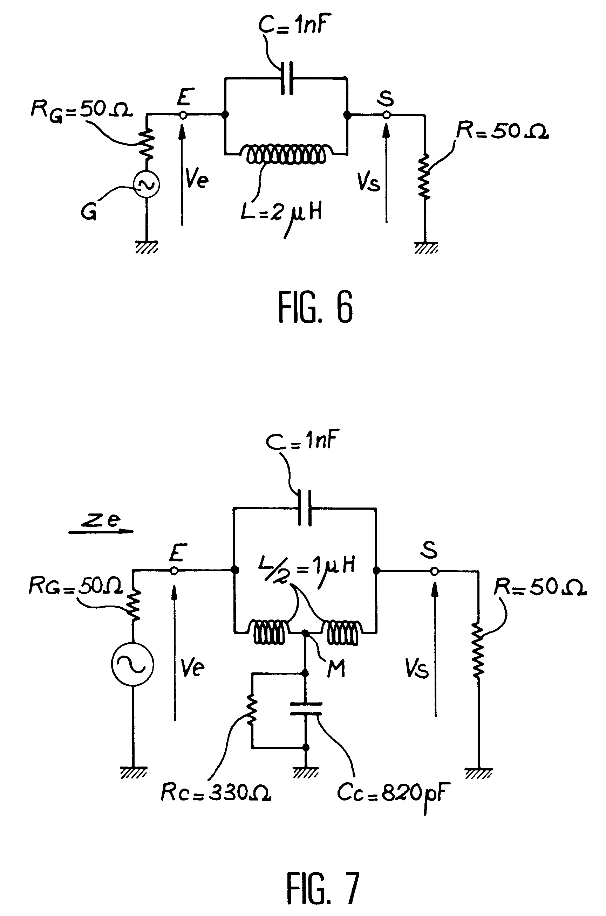

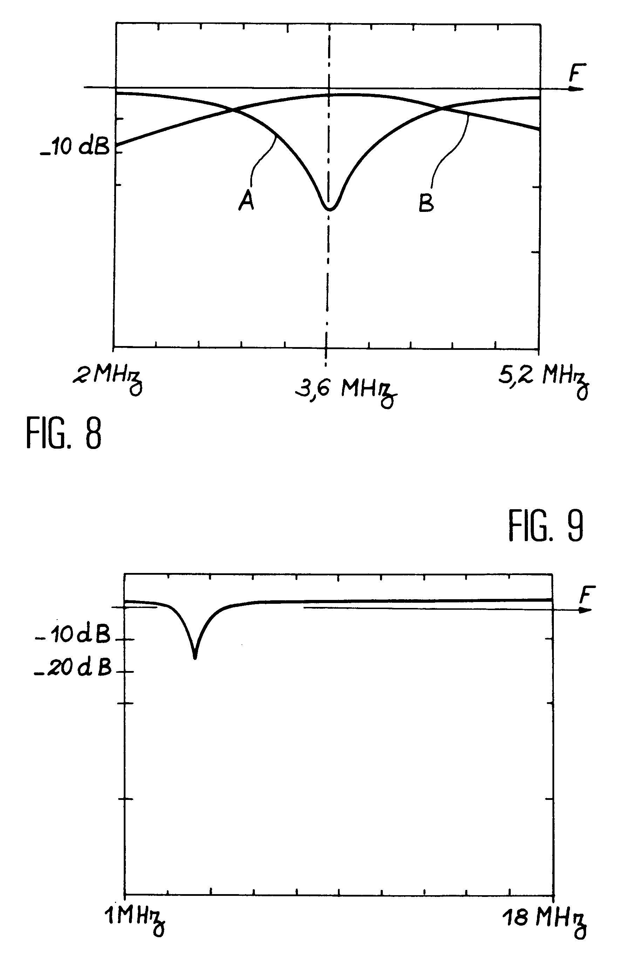

Les courbes des figures 8 à 11 permettent de mieux apprécier les améliorations apportées par l'invention. La figure 6 correspond tout d'abord à un filtre de l'art antérieur, avec une inductance de 2 μH et un condensateur de 1 nF.

La figure 8 montre les performances de ce filtre. L'axe des abscisses porte la fréquence qui va de 2 MHz à 5,2 MHz. La fréquence centrale est égale à 3,6 MHz. L'axe des ordonnées porte l'atténuation avec une échelle de 5 dB par division.

La courbe A correspond à l'atténuation mesurée. Elle est au mieux égale à -18 dB pour Fo=3,6 MHz. La courbe B correspond à la désadaptation qui, en début de gamme, est de -9 dB.

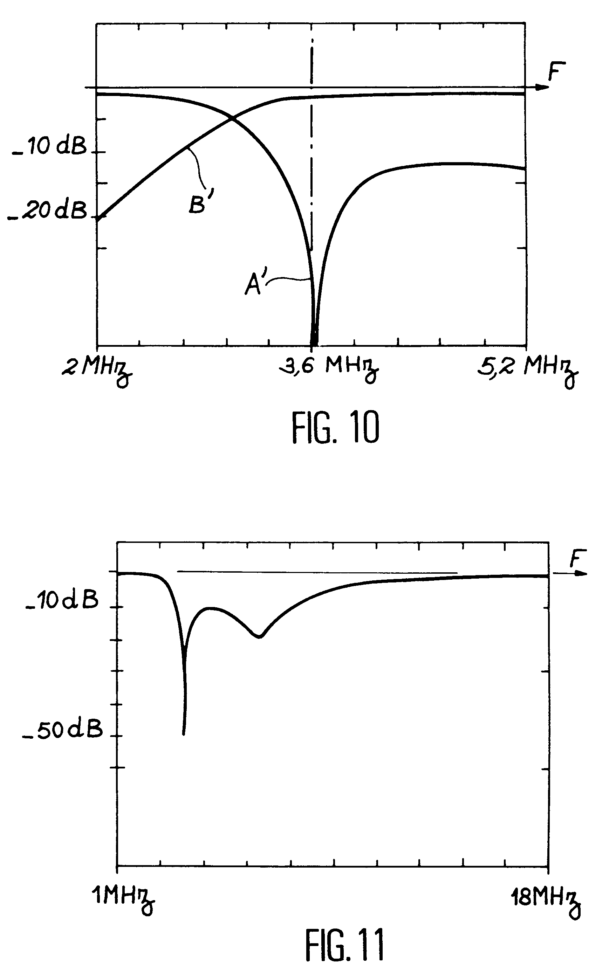

Le même filtre corrigé par un condensateur de valeur Cc=820 pF avec Rc=330 Ω (cf Fig. 7) présente des performances telles qu'illustrées sur la figure 10 avec les mêmes échelles : l'atténuation A' tombe à -40 dB et la désadaptation B' à -20 dB.

Les courbes 9 et 11 permettent de comparer les filtres à composants discrets selon l'art antérieur (Fig. 6) et selon l'invention (Fig. 7). Dans les deux cas, l'axe des abscisses s'étend de 1 MHz à 18 MHz. L'axe des ordonnées porte l'atténuation à raison de 10 dB par division. Un filtre de l'art antérieur présente une atténuation d'environ 18 dB (Fig. 9) alors que le même filtre corrigé selon l'invention, par ajout d'un condensateur, voit son atténuation tomber à -50 dB, ce qui représente une amélioration considérable compte tenu de la modestie de la modification apportée.

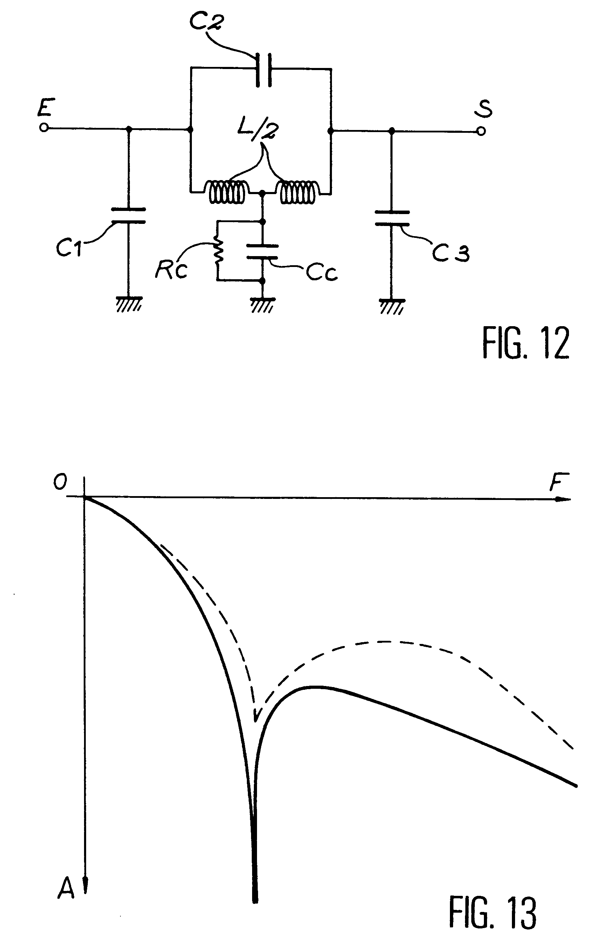

L'invention n'est pas limitée aux cellules de type résonnant-parallèle, montées en série, mais s'étend à d'autres types comme les cellules en π dont un exemple est donné figure 12. Une telle cellule comprend trois condensateurs C1, C2, C3, et selon l'invention, une inductance formée de deux demi-inductances L/2, avec un condensateur de correction Cc ayant une résistance parallèle Rc.

La courbe d'atténuation correspondante est représentée sur la figure 13 en trait plein ; la partie en tirets montre la courbe obtenue sans correction, selon l'art antérieur.

L'invention n'est pas limitée non plus à une seule cellule de filtrage mais englobe tout filtre à plusieurs cellules dont l'une au moins est corrigée comme il vient d'être expliqué.

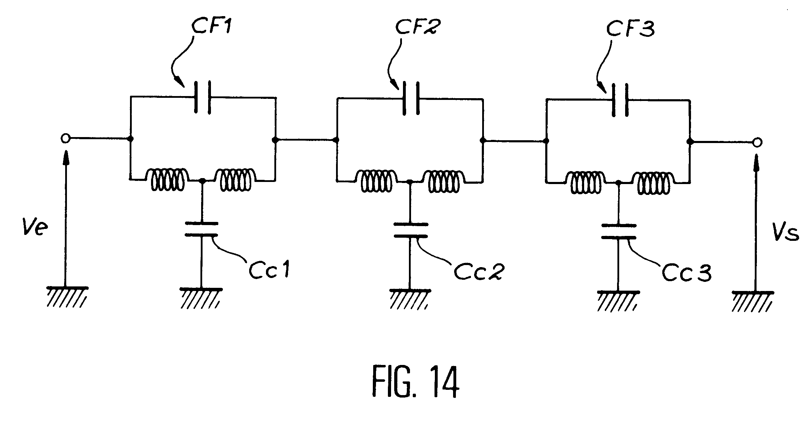

La figure 14 montre ainsi un filtre à trois cellules de filtrage CF1, CF2, CF3, toutes trois conformes à l'invention, avec trois condensateurs de correction Cc1, Cc2, Cc3. Les fréquences de réjection peuvent être toutes différentes. Les coefficients de qualité des condensateurs Cc1, ..., doivent être de valeur identique à celle des coefficients de qualité des inductances associées.

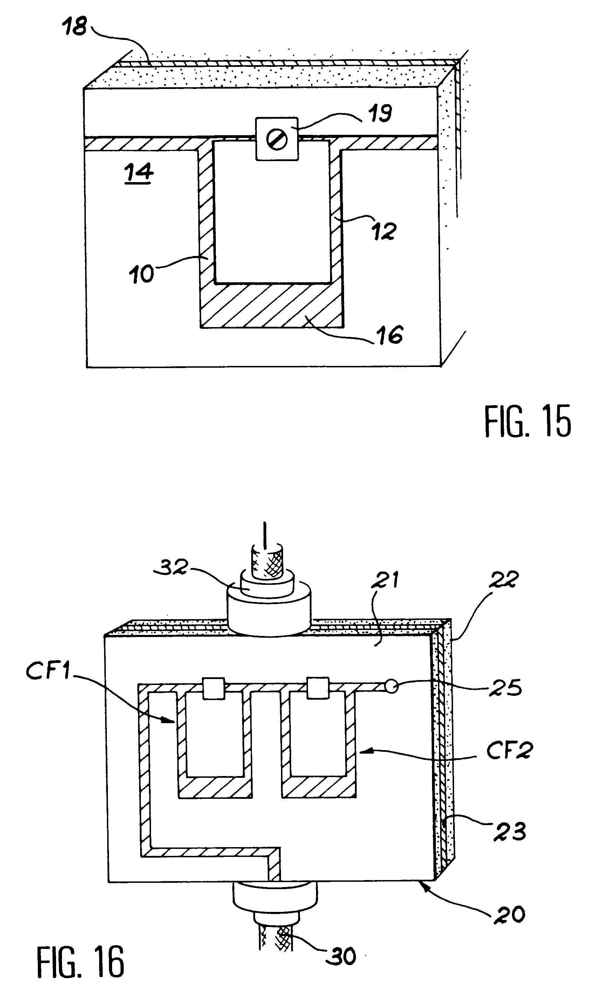

Bien que cette première variante de l'invention puisse être réalisée en composants discrets, il est plus commode, lorsque la plage de fréquence de travail atteint et dépasse le Gigahertz, de réaliser l'inductance du filtre sous forme de micro-ruban conducteur. L'invention se prête particulièrement bien à cette technologie. En effet, dans ce cas et comme représenté sur la figure 15, une cellule de filtrage selon l'invention peut comprendre deux micro-rubans 10 et 12 déposés sur un substrat isolant 14. Ces deux micro-rubans, qui peuvent être de forme géométrique quelconque, constituent deux demi-inductances, et comprennent en outre un micro-ruban 16. Ce micro-ruban 16 forme, avec un plan de masse 18 déposé sur l'autre face du substrat, le condensateur de correction. Un condensateur discret 19 complète l'ensemble.

On voit donc que, dans cette technologie, le condensateur de correction 16 s'intègre tout naturellement entre les deux demi-inductances 10, 12. Il suffit de régler la largeur du micro-ruban 16 pour obtenir la capacité appropriée Cc.

Plusieurs cellules de ce genre peuvent être mises bout à bout sur un même substrat. On peut aussi replier le substrat comme représenté sur la figure 16. Un substrat 20 est constitué de deux plaquettes isolantes 21 et 22 séparées par un plan conducteur 23. Sur la face avant de la plaquette 21, on trouve deux cellules de filtrage similaires à celle de la figure 15, soit CF1 et CF2. Un trou métallisé 25 (isolé du plan 23) permet d'établir une connexion électrique avec la face arrière de la plaquette 22, laquelle comprend deux cellules analogues à CF1 et CF2 (non visibles sur la figure). L'entrée et la sortie du filtre s'effectuent respectivement par les connecteurs 30 et 32.

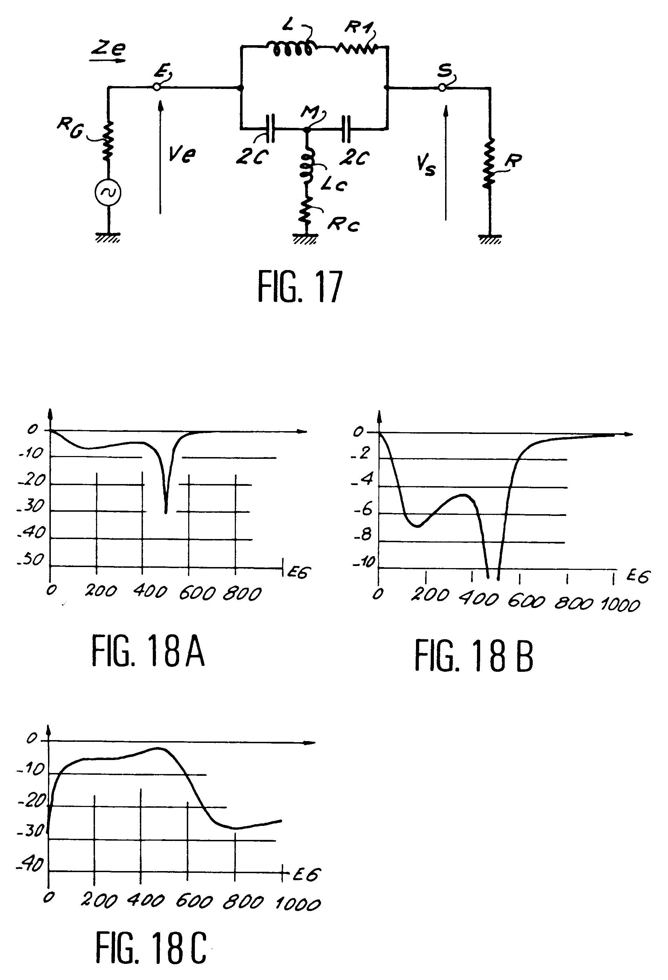

Les différents modes de réalisation qui viennent d'être décrits correspondent au cas où c'est sur l'inductance du circuit résonnant que la correction est effectuée et ce, par un condensateur de coefficient de qualité ad hoc. Mais l'invention couvre le cas où c'est sur le condensateur du circuit résonnant que la correction est effectuée et ceci par une inductance associée à une résistance. La cellule correspondante est illustrée sur la figure 17. Le condensateur est scindé en deux condensateurs de valeur 2C connectés en série avec un point milieu M. Entre ce point et la masse sont connectées une inductance de valeur Lc et une résistance de correction Rc en série. Par ailleurs, l'inductance principale L est associée à une résistance $R_1$, $R_1$ étant lié au facteur de qualité de L. Les autres moyens sont identiques à ceux de la figure 4.

Les figures 18A, B, C illustrent les performances obtenues. Les résultats illustrés sont à comparer respectivement aux résultats illustrés sur les figures 3B, 3D et 3F relatifs à une cellule de l'art antérieur. On voit en particulier sur la figure 18A une atténuation de -32 dB à la fréquence de réjection (à comparer à -28 dB) ; sur la figure 18B des pertes de 0,4 dB à 800 MHz et de 1,5 dB à 600 MHz (à comparer respectivement à 1,2 et 2,5 dB) ; et enfin, sur la figure 18C, une désadaptation de -26 dB à 800 MHz (à comparer à -13 dB).

Les travaux théoriques et expérimentaux des inventeurs ont montré qu'il existe un large choix pour les valeurs des éléments de correction Lc et Rc. La valeur maximum de Lc est $1/2R_1C^2w_o^3$ et dans ce cas la résistance de correction Rc est égale à $L_cw_o$. Il faut imposer ensuite $L = \dfrac{2}{Cw_o^2} - Lc\dfrac{R_1}{Rc}$

Si l'on choisit une valeur de Lc inférieure à la valeur maximale, alors Rc peut prendre deux valeurs :

$$R_{c1} = \frac{1 + \sqrt{A}}{2K} \text{ ou } R_{c2} = \frac{1 - \sqrt{A}}{2K}$$

avec $K = R_1C^2w_o^2$
et $A = 1 - 4K^2Lc^2w_o^2$

et il faut toujours imposer $L = \dfrac{2}{Cw_o^2} - Lc\dfrac{R_1}{Rc}$

Dans ces relations L et $R_1$ sont l'inductance du circuit résonnant avec sa résistance parasite associée qui détermine le coefficient de qualité, C est la capacité du condensateur du circuit résonnant, $w_o$ est la pulsation de résonance choisie avec $w_o = 2\pi Fo$, Fo étant la fréquence de résonance.

## Revendications

1.  Cellule de filtrage comprenant un circuit résonnant parallèle composé d'au moins une inductance (L) et d'au moins un condensateur (C), caractérisée par le fait que l'inductance (L) est séparée en deux inductances connectées en série (L/2, L/2) avec un point milieu (M), et par le fait qu'elle comprend un condensateur de correction connecté audit point milieu, ce condensateur de correction ayant une capacité (Cc) de valeur sensiblement égale à $L/R^2$, où L est la valeur de l'inductance et R la valeur de l'impédance de charge de la cellule, le condensateur de correction ayant un coefficient de qualité sensiblement égal au coefficient de qualité de l'inductance (L).

2.  Cellule de filtrage selon la revendication 1, caractérisée par le fait qu'elle comprend une seule inductance et un seul condensateur en parallèle, l'ensemble constituant une cellule de type résonnant-parallèle, montée en série.

3.  Cellule de filtrage selon la revendication 1, caractérisée par le fait que l'inductance est constituée par deux micro-rubans conducteurs (10, 12) déposés sur une face d'un substrat isolant (14) et que le condensateur de correction est constitué par un micro-ruban conducteur (16) déposé sur Ledit substrat (14) entre les deux micro-rubans (10, 12) constituant l'inductance, un plan conducteur (18) étant déposé sur l'autre face du substrat (14).

4.  Cellule de filtrage selon la revendication 1, caractérisée par le fait que le condensateur de correction est réparti le long d'au moins une partie de l'inductance corrigée.

5.  Cellule de filtrage comprenant un circuit résonnant parallèle composé d'au moins une inductance (L) et d'au moins un condensateur (C), caractérisée par le fait que le condensateur est séparé en deux condensateurs connectés en série (2C, 2C) avec un point milieu (M) et par le fait qu'elle comprend une inductance de correction de valeur Lc associée à une résistance de valeur Rc et connectée audit point milieu, cette inductance de correction étant non nulle et inférieure ou égale sensiblement à $1/2R_1C^2w_o^3$ où C est la valeur du condensateur, $R_1$ la résistance de l'inductance (L) et $w_0$ la pulsation de résonance.

6.  Cellule de filtrage selon la revendication 5, caractérisée par le fait que l'inductance de correction est égale sensiblement à $1/2R_1C^2w_o^3$ et que la valeur de Rc est prise sensiblement égale à $LCw_0$ avec
$$L = (2/Cw_0^2) - Lc(R_1/Rc).$$

7.  Cellule de filtrage selon la revendication 6, caractérisée par le fait que la valeur (Lc) de l'inductance de correction est prise inférieure à $1/2R_1C^2w_0^3$ et la valeur de Rc est prise égale à l'une des deux valeurs Rc1, Rc2 :
$$Rc1 = \frac{1 + \sqrt{A}}{2K}$$

$$Rc2 \;=\; \frac{1 - \sqrt{A}}{2K}$$

avec $K = R_1C^2w_0^2$

$A = 1 - 4K^2Lc^2w_0^2$

et $L = \dfrac{2}{Cw_0^2} - Lc\,\dfrac{R_1}{Rc}.$

8. Filtre comprenant une pluralité de cellules de filtrage, caractérisé par le fait qu'au moins l'une de ces cellules est conforme à la cellule selon l'une quelconque des revendications 1 à 7.

## Patentansprüche

1. Filtereinheit, die einen parallelen Resonanzkreis umfaßt, der aus wenigstens einer Induktivität (L) und wenigstens einem Kondensator (C) gebildet ist, **dadurch gekennzeichnet,** daß die Induktivität (L) in zwei Induktivitäten getrennt ist, die in Reihe (L/2, L/2) mit einem Mittelpunkt (M) verbunden sind, und daß sie einen Korrekturkondensator umfaßt, der mit dem genannten Mittelpunkt verbunden ist, wobei dieser Korrekturkondensator eine Kapazität (Cc) mit einem Wert im wesentlichen gleich $L/R^2$ aufweist, wo L der Wert der Induktivität und R der Wert der Verbraucherimpedanz der Einheit ist, der Korrekturkondensator eine Güte hat, die im wesentlichen gleich der Güte der Induktivität (L) ist.

2. Filtereinheit gemäß Anspruch 1, **dadurch gekennzeichnet,** daß sie eine einzige Induktivität und einen einzigen dazu parallelen Kondensator umfaßt, wobei die Gesamtheit eine Einheit vom parallel schwingenden Typ bildet, die in Reihe geschaltet ist.

3. Filtereinheit gemäß Anspruch 1, **dadurch gekennzeichnet,** daß die Induktivität von zwei Mikroleiterbändern (10, 12) gebildet ist, die auf einer Seite eines isolierenden Substrats (14) abgeschieden sind, und daß der Korrekturkondensator von einem Mikroleiterband (16) gebildet ist, der auf dem genannten Substrat (14) zwischen den zwei Mikroleiterbändern (10, 12) abgeschieden ist, die die Induktivität bilden, ein ebener Leiter (18) auf der anderen Seite des Substrats (14) abgeschieden ist.

4. Filtereinheit gemäß Anspruch 1, **dadurch gekennzeichnet,** daß der Korrekturkondensator entlang wenigstens einem Teil der korrigierten Induktivität verteilt ist.

5. Filtereinheit, die eine parallel schwingende Schaltungsanordnung umfaßt, die aus wenigstens einer Induktivität (L) und wenigstens einem Kondensator (C) gebildet ist, **dadurch gekennzeichnet,** daß der Kondensator in zwei in Reihe verbundene Kondensatoren (2C, 2C) mit einem Mittelpunkt (M) getrennt ist, und daß sie eine Korrekturinduktanz mit dem Wert Lc umfaßt, die mit einem Widerstand vom Wert Rc verbunden ist und mit dem genannten Mittelpunkt verbunden ist, wobei diese Korrekturinduktivität nicht Null und kleiner oder im wesentlichen gleich $1/2R_1C^2w_0^3$ ist, w0 C der Wert des Kondensators, $R_1$ der Widerstand der Induktivität (L) und $w_0$ die Resonanzschwingung ist.

6. Filtereinheit gemäß Anspruch 5, **dadurch gekennzeichnet,** daß die Korrekturinduktivität im wesentlichen gleich $1/2R_1C^2w_0^3$ ist und daß der Wert von Rc im wesentlichen gleich $LCw_0$ genommen ist, mit

$$L = (2/Cw_0^2) - Lc(R_1/Rc).$$

7. Filtereinheit gemäß Anspruch 6, **dadurch gekennzeichnet,** daß der Wert (Lc) der Korrekturinduktivität kleiner als $1/2R_1C^2w_0^3$ genommen wird und der Wert von Rc gleich einem der zwei Werte Rc1, Rc2 genommen wird:

$$Rc1 \;=\; \frac{1 + \sqrt{A}}{2K}$$

$$Rc2 \;=\; \frac{1 - \sqrt{A}}{2K}$$

mit $K = R_1C^2w_0^2$

$A = 1 - 4K^2Lc^2w_0^2$

und $L = \dfrac{2}{Cw_0^2} - Lc\,\dfrac{R_1}{Rc}.$

8. Filter, der eine Vielzahl von Filtereinheiten umfaßt, **dadurch gekennzeichnet,** daß wenigstens eine dieser Einheiten mit der Einheit gemäß irgendeinem der Ansprüche 1 bis 7 übereinstimmt.

## Claims

1. Filtering cell comprising a parallel resonant circuit constituted by at least one inductance (L) and at least one capacitor (C), characterized in that the inductance (L) is separated into two inductances connected in series (L/2, L/2) with a centre point (M) and in that it comprises a correction capacitor connected to said centre point, said correction capacitor having a capacitance (Cc) of values substantially equal to $L/R^2$, in which L is the value of the inductance and R the value of the load impedance of the cell, the correction capacitor having a quality coefficient substantially equal to the quality coefficient of the inductance (L).

2. Filtering cell according to claim 1, characterized in that it comprises a single inductance and a single capacitor in parallel, the assembly constituting a series-connected, resonant - parallel-type cell.

3. Filtering cell according to claim 1, characterized in that the inductance is constituted by two conductive micro-strips (10, 12) deposited on one face of an insulating substrate (14) and that the correction capacitor is constituted by a conductive microstrip (16) deposited on said substrate (14) between the two microstrips (10, 12) constituting the inductance, a conductive plane (18) being deposited on the other face of the substrate (14).

4. Filtering cell according to claim 1, characterized in that the correction capacitor is distributed along at least one part of the corrected inductance.

5. Filtering cell incorporating a parallel resonance circuit constituted by at least one inductance (L) and at least one capacitor (C), characterized in that the capacitor is separated into two capacitors (2C, 2C) connected in series with a centre point (M) and in that it comprises a correction inductance of value Lc associated with a resistor of value Rc and connected to said centre point, said correction inductance being non-zero and equal to or below essentially $1/2R_1C^2w_0^3$ in which C is the value of the capacitor, $R_1$ the resistance of the inductance (L) and $w_0$ the resonance pulsation.

6. Filtering cell according to claim 5, characterized in that the correction inductance is substantially equal to $1/2R_1C^2w_0^3$ and the value of Rc is substantially equal to $LCw_0$ with
$$L = (2/Cw_0^2) - Lc(R_1Rc)$$

7. Filtering cell according to claim 6, characterized in that the value (Lc) of the correction inductance is below $1/2R_1C^2w_0^3$ and the value of Rc is equal to one of the two values Rc1, Rc2:
$$Rc1 = \frac{1 + \sqrt{A}}{2K}$$
$$Rc2 = \frac{1 - \sqrt{A}}{2K}$$
with
$$K = R_1C^2w_0^2$$
$$A = 1-4K^2Lc^2w_0^2 \text{ and}$$
$$L = \frac{2}{Cw_0^2} - Lc\frac{R_1}{Rc}$$

8. Filter comprising a plurality of filtering cells, characterized in that at least one of the cells is in accordance with the cell of any one of the claims 1 to 7.

FIG. 1

FIG. 2 A

FIG. 2 B

EP 0 424 255 B1

FIG. 3 A

FIG. 3 C

FIG. 3 E

FIG. 3 B

FIG. 3 D

FIG. 3 F

FIG. 4

FIG. 5

$C = 1nF$

$R_G = 50\,\Omega$   $E$   $S$   $R = 50\,\Omega$

$G$   $Ve$   $L = 2\,\mu H$   $Vs$

## FIG. 6

$C = 1nF$

$\underrightarrow{Ze}$

$RG = 50\,\Omega$   $E$   $L/2 = 1\,\mu H$   $S$   $R = 50\,\Omega$

$Ve$   $M$   $Vs$

$Rc = 330\,\Omega$   $Cc = 820pF$

## FIG. 7

FIG. 8

FIG. 9

FIG. 10

FIG. 11

FIG. 12

FIG. 13

FIG. 14

FIG. 15

FIG. 16

FIG. 17

FIG. 18 A

FIG. 18 B

FIG. 18 C